# EUROPEAN PATENT APPLICATION

(11) **EP 1 585 148 A1**
(43) Date of publication of application: **12.10.2005**
(21) Application number: 03778965.8
(22) Date of filing: 16.12.2003
(51) Int. Cl.: H01F 10/16

(54) **GRANULAR SUBSTANCE, MAGNETIC THIN FILM, AND MAGNETIC DEVICE**

(30) Priority: 27.12.2002 JP 2002381917
(71) Applicant: TDK Corporation, Tokyo 103-8272 (JP)
(72) Inventor: CHOI, Kyung-Ku, c/o TDK Corporation, Tokyo 103-8272 (JP); MURASE, Taku, c/o TDK Corporation, Tokyo 103-8272 (JP); HIRATSUKA, Nobuyuki, c/o Saitama University, Saitama-city, Saitama 338-8570 (JP); KAKIZAKI, Kouichi, c/o Saitama University, Saitama-city, Saitama 338-8570 (JP)
(74) Representative: HOFFMANN EITLE
(86) International application number: PCT/JP2003/016097
(87) International publication number: WO 2004/061876

(57) **Abstract**

A granular substance (1) having soft magnetic properties is provided which contains a matrix (3) composed of a nonmagnetic insulating organic material and ferromagnetic metal particles (2) dispersed in the matrix (3) and having a mean particle size of 50 nm or less, wherein the volume ratio of the matrix (3) is in the range of 5 to 50%. When the granular substance (1) is in the form of a film, it has a complex permeability the real part (µ') of which is 40 or more at 1 GHz, a quality factor Q (Q = µ'/µ" where µ" is the imaginary part of the complex permeability) of 1 or more, and a saturation magnetization of 5 kG or more.

## Description

### Technical Field

The present invention relates to a granular substance, particularly a granular thin film, having ferromagnetic metal fine particles dispersed in a nonmagnetic insulating organic material.

### Background Art

With the downsizing and performance improvement of magnetic devices, a magnetic thin film material having a high saturation magnetization and having a high permeability in the high frequency of GHz region is required.

For example, monolithic microwave integrated circuits (MMICs) growing in demand notably for wireless transmitters/receivers and portable information terminals are high frequency integrated circuits formed by collectively and integrally fabricating active devices such as a transistor and passive devices such as a transmission line, a resistor, a capacitor and an inductor on a semiconductor substrate of Si, GaAs, InP or the like.

In such a MMIC, passive devices, particularly the inductor and the capacitor, occupy a large area compared with active devices. Such occupation of a large area by the passive device resultantly leads to heavy consumption of expensive semiconductor substrates and hence an increase in cost of the MMIC. Therefore, the problem is to decrease the area occupied by the passive device for decreasing the chip area and reducing manufacturing costs of the MMIC.

As inductors used in the MMIC, planar spiral coils are often used. A method in which a soft magnetic thin film is inserted on the top and bottom side of the spiral coil or either side thereof to increase an inductance (in other words, a method allowing a conventional inductance to be obtained even with a small occupied area) has been already proposed (e.g. J. Appl. Phys. 85,7919 (1999)).

However, for applying a magnetic material to the inductors used in the MMIC, it is required to develop a thin film magnetic material having a high permeability in the high frequency of GHz region and being less susceptible to losses in the first place. Further, an increased resistivity is required.

As a magnetic material having a high saturation magnetization, Fe, or a fine crystal or amorphous alloy having Fe as a main component has been known. However, if a magnetic film of a Fe based alloy is fabricated by a deposition technique such as sputtering, the film has a high saturation magnetization, but has an increased coercive force and a reduced resistivity, and it is thus difficult to obtain satisfactory high frequency properties.

As a material excellent in soft magnetic properties, a Co based amorphous alloy is known. The Co based amorphous alloy is mainly comprising an amorphous material having Co as a main component and comprising at least one element selected from Y, Ti, Zr, Hf, Nb, Ta and the like. However, if a magnetic film of a Co based amorphous alloy having a zero magnetostrictive composition is fabricated by a deposition technique such as sputtering, the film has a high permeability, but its saturation magnetization is about 11 kG (1.1T), which is lower than that of the Fe based one. Further, at frequencies of about 100 MHz and higher, a loss component (imaginary part µ" of complex permeability) increases, a quality factor Q value becomes 1 or less, and thus it cannot be said that the Co based amorphous alloy is suitable as a magnetic material which is used in the high frequency of GHz region.

Under such a circumstance, various proposals have been made for improving the high frequency properties of a soft magnetic thin film. As a basic policy for the improvement, an eddy current loss is inhibited, a resonance frequency is increased, or the like. As a specific measure for inhibiting the eddy current loss, use of a granular thin film has been proposed (e.g. J. Appl. Phys. 79, 5130 (1996)).

As for a thin film having a granular structure, it has a structure of fine ferromagnetic particles dispersed in a matrix composed of a nonmagnetic material, and nonmagnetic metal-ferromagnetic metal systems and nonmagnetic insulator-ferromagnetic metal systems have been developed.

The nonmagnetic metal-ferromagnetic metal system can be applied as a magnetic head material utilizing a magnetic resistance effect (e.g. Japanese Patent No. 2701743). The nonmagnetic insulator-ferromagnetic metal system can be applied as a magnetic head material (e.g. Japanese Patent No. 3075332), an inductor material for high frequency (e.g. J. Ceram. Soc. Japan, 110 (5), 432 (2002)) oraradiowaveabsorbent material for high frequency (Japanese Patent Laid-Open No. 2001-210518, Japanese Patent Laid-Open No. 2002-158486) according to the amount of nonmagnetic insulator.

In the field of conventional magnetic recording media, composite thin films composed of an organic material and a ferromagnetic material have been developed (e.g. Japanese Patent Laid-Open No. 61-178731, Japanese Patent Publication No. 3-77575), but the composite thin film is optimized for application to magnetic recording media, therefore has a high coercive force of several hundred Oe and cannot be applied to products requiring a high permeability.

Recently, composite thin films of CoPt or FePt alloy and a fluorocarbon polymer have been reported as magnetic recording media (e.g. Journal of The Magnetic Society of Japan, vol 26, No. 4, 2002, p. 280-283; and Journal of Magnetic Society of Japan, vol. 27, No. 4, 2003, p. 336-339). However, these composite thin films have a high coercive force of 3000 Oe or greater, and are difficult to apply as a magnetic material for high frequency. Furthermore, there is a disadvantage that the material of the substrate is limited because heat treatment at a high temperature of 300 to 600°C is involved in the process of production, and so on.

Conventionally, the nonmagnetic insulator-ferromagnetic metal system granular thin film is obtained by depositing a nonmagnetic insulator of ceramics (oxide, nitride or fluoride) and a ferromagnetic metal at the same time by a sputtering method or the like. However, in the conventional granular thin film, there are cases where the surfaces of ferromagnetic metal fine particles react with an insulator during deposition to degrade the magnetic properties, thus making it impossible to obtain desired magnetic properties. Furthermore, such a thin film is difficult to apply to a flexible magnetic device because an inorganic material forming the thin film is hard and lacking in flexibility.

The present invention has been devised under such a circumstance, and has an object of providing a granular substance and a magnetic thin film capable of being used as a magnetic thin film for high frequency having a high permeability in the high frequency of GHz region and having a high saturation magnetization. Furthermore, the present invention has an object of providing a magnetic device using such a magnetic thin film.

### Disclosure of the Invention

Under such objects, the present invention provides a granular substance comprising a matrix composed of a nonmagnetic insulating organic material, and ferromagnetic metal particles dispersed in the matrix and having a mean particle size of 50 nm or less, characterized in that the volume ratio of the matrix is in the range of 5 to 50 vol%.

In the granular substance of the present invention, the ferromagnetic metal particlesare preferably formed of an alloy mainly comprising at least one selected from Fe, Co and Ni.

Particularly, by forming the ferromagnetic metal particles from a metal mainly comprising Fe and Co, a high saturation magnetization can be obtained.

In this case, the concentration of Co in the metal mainly comprising Fe and Co is preferably in the range of 10 to 50 at%.

In the granular substance of the present invention, the ferromagnetic metal particles may be spaced apart by a distance enabling exchange coupling there between.

In the granular substance of the present invention, the matrix is preferably formed of an organic polymer.

The volume ratio of the matrix in the granular substance is preferably in the range of 5 to 40%.

The granular substance of the present invention typically is in the form of a film. In this case, it may have a complex permeability the real part (µ') of which is 40 or more at 1 GHz, a quality, factor Q (Q = µ'/µ" where µ" is the imaginary part of the complex permeability) is 1 or more, and a saturation magnetization of 5 kG (0.5 T) or more.

The granular substance of the present invention may also have a complex permeability the real part (µ') of which is 50 or more at 1 GHz, a quality factor Q (Q = µ'/µ" where µ" is the imaginary part of the complex permeability) is 5 or more, and a saturation magnetization of 6 kG or more.

The granular substance of the present invention may have a resistivity of 100 µΩcm or more.

According to the present invention is provided a magnetic thin film having an in-plane magnetic anisotropy and having a thickness of 100 to 2000 nm, characterized in that the magnetic thin film is composed of a mixture of ferromagnetic metal particles mainly comprising at least one selected from Fe, Co and Ni and having a mean particle size of 50 nm or less and an organic polymer, and in this mixture, the ferromagnetic metal particles are spaced apart by a distance enabling exchange coupling there between.

In the magnetic thin film of the present invention, the ferromagnetic metal particles are preferably formed of a metal mainly comprising Fe and Co.

The mean particle size of the ferromagnetic metal particles is preferably in the range of 5 to 15 nm.

For the organic polymer forming the magnetic thin film of the present invention, polyimide or tetrafluoroethylene (trade name: Teflon) is suitable.

Further, according to the present invention is provided a magnetic device having a magnetic thin film for high frequency, characterized in that the magnetic thin film for high frequency is formed of a granular substance comprising a matrix composed of a nonmagnetic insulating organic material and ferromagnetic metal particles dispersed in the matrix and having a mean particle size of 50 nm or less, wherein the volume ratio of the matrix is in the range of 5 to 50%.

In the magnetic device of the present invention, the mean particle size of the ferromagnetic metal particles is preferably in the range of 5 to 30 nm.

In the magnetic device of the present invention, it is effective to form the ferromagnetic metal particles from a metal mainly comprising Fe and Co in obtaining a high saturation magnetization.

In the magnetic device of the present invention, the matrix forming the magnetic thin film for high frequency may be formed of an organic polymer.

By employing a fluorocarbon polymer as the organic polymer, the magnetic thin film for high frequency can be made to have a resistivity of 300 µΩcm or more.

In the magnetic device of the present invention, the magnetic thin film for high frequency preferably has a complex permeability the real part (µ') of which is 40 or more at 1 GHz, a quality factor Q (Q = µ'/µ" where µ" is the imaginary part of the complex permeability) of 1 or more, and a saturation magnetization of 5 kG or more.

### Brief Description of the Drawings

FIG. 1 is a view schematically showing a structure of a granular substance according to the present invention;
FIG. 2 is a view schematically showing one example of a granular thin film forming apparatus (hereinafter referred to as "thin film forming apparatus" in some cases) using a vapor deposition polymerization method and a sputtering method in combination;
FIG. 3 is a view for explaining an anisotropy formed in a granular thin film;
FIG. 4 is a view schematically showing one example of the thin film forming apparatus using the sputtering method;
FIG. 5 is a view schematically showing one example of the thin film forming apparatus using a plasma polymerization method and a sputtering method in combination;
FIG. 6 is a plan view showing one example of an integrated inductor;
FIG. 7 is a cross-sectional view taken along the line A-A of FIG. 6;
FIG. 8 is a table showing magnetic properties and the like of samples No. 1 to 5 obtained in the fifth example;
FIG. 9 shows X-ray diffraction patterns of samples No. 1 to 4 obtained in the fifth example;
FIG. 10A shows a TEM (transmission electron microscope) photograph of the sample No. 2;
FIG. 10B shows a TEM photograph of the sample No. 4; and
FIG. 11 shows an electron beam diffraction pattern of the sample No. 2.

### Best Mode for Carrying Out the Invention

Embodiments of the present invention will be described below.

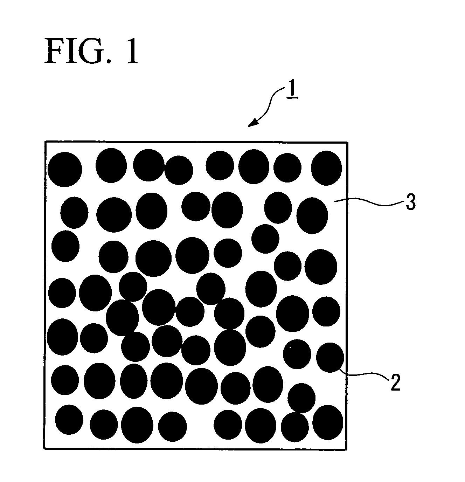

FIG. 1 is a view schematically showing a structure of a granular substance 1 in this embodiment. The granular substance 1 has a structure in which ferromagnetic metal particles 2 are dispersed in a matrix 3 formed of a nonmagnetic insulating organic material. The granular substance 1 having such a structure is typically used as a thin film in practice. It is important that the thin film has soft magnetic properties and excellent high frequency properties in achieving the object of the present invention.

For obtaining the soft magnetic properties, it is important that the ferromagnetic metal particles 2 has a mean particle size of 50 nm or less, the spins of the ferromagnetic metal particles 2 are in random orientations, and the distance between the ferromagnetic metal particles 2 is a distance enabling exchange coupling therebetween.

As the ferromagnetic metal particles 2, a metal mainly comprising at least one selected from Fe, Co and Ni is employed. Consequently, the coercive force and saturation magnetization of the granular substance 1 can be adjusted. Specifically, in addition to pure Fe, pure Co and pure Ni, FeCo based alloys, FeNi based alloys, CoNi based alloys and FeCoNi based alloys may be used. Among them, the FeCo based alloy is preferable as the ferromagnetic metal particles 2. This is because the saturation magnetization obtained with the FeCo based alloy is higher than the saturation magnetization obtained with Fe. The content of Co in the FeCo alloy may be appropriately determined within a range not greater than 80 at%, but is preferably in the range of 10 to 50 at %.

The alloy may comprise metal elements or nonmetal elements other than Fe, Co and Ni within the bounds not harming the object of the present invention.

The coercive force is proportional to the sixth power of the particle size of the ferromagnetic metal particles 2 when the particle size of the ferromagnetic metal particles 2 is in the range of 100 nm or less. Namely, by decreasing the particle size of the ferromagnetic metal particles 2, the coercive force can be restricted to a low value. Thus, the granular substance 1 of the present invention has the mean particle size of the ferromagnetic metal particles 2 restricted to 50 nm or less. The mean particle size of the ferromagnetic metal particles 2 is preferably 30 nm or less, more preferably in the range 5 to 30 nm.

For obtaining the soft magnetic properties, it is important that the distance between the ferromagnetic metal particles 2 is a distance enabling exchange coupling therebetween as described above. In the present invention, the distance between the ferromagnetic metal particles 2 can be adjusted by the volume ratio of the matrix 3. If the volume ratio of the matrix 3 exceeds 50%, the distance between the ferromagnetic metal particles 2 becomes so large that exchange coupling force between the ferromagnetic metal particles 2 is lost. Thus, in the present invention, the volume ratio of the matrix 3 formed of the nonmagnetic insulating organic material is 50% or less. If the amount of the matrix 3 is small, the particle size of the ferromagnetic metal particles 2 can be no longer decreased in the granular substance 1 obtained by the method described later. For limiting the mean particle size of the ferromagnetic metal particles 2 to the range of the present invention, i.e. 50 nm or less, it is preferable that the volume ratio of the matrix 3 is 5% or more. The volume ratio of the matrix 3 is preferably in the range of 5 to 40%, more preferably 10 to 40%.

For the nonmagnetic insulating organic material forming the matrix 3, a well known organic polymer may be used. Organic polymers include, in addition to synthetic resin polymers, polymerizable monomers and oligomers to produce these polymers by polymerization. For example, ultraviolet and electron beam curable resins of acryl monomers or oligomers such as hydroxyethyl acrylate, hexanediol diacrylate, neopentylglycol diacrylate, methyl-α-chloroacrylate, trimethylolpropane triacrylate, dipentaol hexacrylate, trimethylolpropane tridiethylene glycolacrylate and urethane acrylate may be used. As the organic polymer forming the matrix 3, polyimide, polytetrafluoroethylene (tetrafluoroethylene), polyethylene terephthalate, polycarbonate, polyparaxylene, polypropylene, polyethylene, polystyrene, trifluorochloroethylene, allyltrifluoroacetylene, adipic acid-hexamethylenediamine oligomer and silicone oil may be used.

By forming the matrix 3 with a nonmagnetic insulating organic material represented by the organic polymer, the granular substance 1 of the present invention is highly flexible compared with the conventional granular substance having an inorganic material as the matrix, and has an excellent stress resistance such that damages such as cracking and chipping are hard to occur even if a mechanical stress is applied.

The typical form of the granular substance 1 according to the present invention is the form of a thin film as described above. The thin film can have satisfactory high frequency properties. Namely, assuming that by forming the matrix 3 from a nonmagnetic insulating organic material, a high resistivity can be achieved to reduce an eddy current loss, and therefore satisfactory high frequency properties are obtained, in addition to the fact that the granular substance 1 has the soft magnetic properties described above and an in-plane magnetic anisotropy can be imparted to a thin film obtained by the method described later, the thickness of the thin film is preferably in the range of 50 to 2000 nm depending on the resistivity of the granular substance 1 . The thickness is more preferably in the range of 100 to 500 nm.

The thin film using the granular substance 1 according to the present invention can have a complex permeability the real part (µ') of which is 40 or more at 1 GHz, preferably 50 or more, more preferably 100 or more, further more preferably 200 or more. The thin film can have a quality factor Q (Q = µ'/µ'') of 1 or more, preferably 5 or more, more preferably 10 or more. In the present invention, these properties can be obtained in a state of just a deposited film. Namely, how much time has elapsed after completion of deposition is not concerned, but whether or not the thin film has properties specified in the present invention can be determined according to a value measured in a state in which the thin film is not subjected yet to a treatment such as, for example, a heat treatment after being deposited. However, even if the thin film is subjected to a treatment such as a heat treatment after being deposited, those having properties specified in the present invention is included in the scope of the present invention as a matter of course. The same goes for the properties described below.

The thin film using the granular substance 1 according to the present invention can have a saturation magnetization of 5 kG (0.5 T) or more, preferably 6 kG (0.6 T) or more, more preferably 10 kG (1.0 T) or more, further more preferably 15 kG (1.5 T) or more.

Further, the thin film using the granular substance 1 according to the present invention can have a anisotropic magnetic field of 20 Oe (1591 A/m) or more, preferably 50 Oe (3978 A/m) or more, further preferably 70 Oe (5570 A/m) or more.

Further, the thin film using the granular substance 1 according to the present invention can have a electric resistance of 100 µΩcm or more, preferably 150 µΩcm or more, further preferably 200 µΩcm or more. Particularly, if a fluorocarbon polymer is used as the nonmagnetic insulating organic material forming the matrix 3, the thin film can have a electric resistance of 300 µΩcm or more, preferably 500 µΩcm or more, further preferably 1000 µΩcm or more.

A method suitable for production of a granular thin film according to the present invention will now be described.

The granular thin film of the present invention can be obtained by depositing the nonmagnetic insulating organic material forming the matrix 3 and the ferromagnetic metal particles 2 at the same time in the same system.

A previously well known thin film deposition process may be applied to formation of the matrix 3 composed of the nonmagnetic insulating organic material. For example, a vapor deposition polymerization method, a plasma polymerizationmethod, a sputtering method and a laser abrasion method may be applied.

The vapor deposition polymerization method is a method in which monomers to form a polymer are each heated and evaporated to deposit a polymer on a given substrate. The plasma polymerization method is a method in which monomers are gasified and polymerized by plasma discharge. The sputtering method is a method in which a thin film is formed by sputtering using a plate-like nonmagnetic insulating organic material (e.g. polymer) as a target material. The laser abrasion method is a method in which a nonmagnetic insulating organic material is irradiated with laser light to create abrasion to deposit the nonmagnetic insulating organic material on a substrate. The abrasion refers to a phenomenon in which a target material is scattered in a locally generated high temperature plasma state.

A previously well known thin film deposition process may be applied to formation of the ferromagnetic metal particles 2. For example, PVD (physical vapor deposition, e.g. vapor deposition method, sputtering method, laser abrasion method, etc.) and CVD (chemical vapor deposition) may be applied.

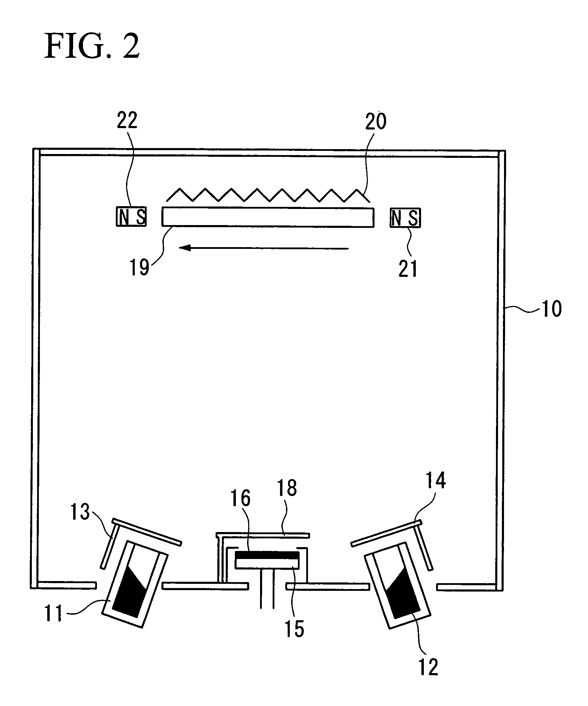

The above-mentioned deposition process is applied to each of the matrix 3 composed of the nonmagnetic insulating organic material and the ferromagnetic metal particles 2 but in the present invention, each process is simultaneously carried out, whereby the granular thin film described above is formed. An example thereof will be described based on FIGS. 2 to 5.

FIG. 2 shows an outlined configuration of an apparatus for forming a granular thin film according to the present invention. In this apparatus, the matrix 3 formed of the nonmagnetic insulating organic material can be obtained by vapor deposition polymerization, and the ferromagnetic metal particles 2 can be obtained by sputtering.

In FIG. 2, the thin film forming apparatus comprises organics evaporating cells 11, 12 in the lower part in a vacuum vessel 10. The organics evaporating cells 11, 12 have a cup shape having an opening in the upper part, and monomers being polymerization raw materials are contained in the organics evaporating cells 11, 12 when a thin film is formed. In the organics evaporating cells 11, 12, heaters (not shown) heating the contained monomers to a predetermined evaporating temperature are provided.

Shutters 13, 14 are placed in the upper parts of the organics evaporating cells 11, 12, respectively. The shutters 13, 14 travel between a position for covering (for closing) the openings of the organics evaporating cells 11, 12 and a position for uncovering (for opening) the openings. FIG. 2 shows a state in which the shutters 13, 14 are closed. At the time when monomers contained in the organics evaporating cells 11, 12 are evaporated, the shutters 13, 14 are closed if it is not desired to scatter the evaporated matter, and the shutters 13, 14 are opened if it is desired to scatter the evaporated matter.

A target mount 15 is placed between the organics evaporating cells 11 and 12, and a target 16 is mounted on the target mount 15. The target 16 is intended for forming the ferromagnetic metal particles 2. A predetermined electric power is applied to the target 16 from a DC/RF power source (not shown), whereby ions are made to impinge on the target 16 at a high speed. Molecules or atoms of elements forming the target 16 are expelled from the surface of the target 16 on which ions have impinged at a high speed. For the target 16, various forms such as an alloy target substantially identical in composition to the ferromagnetic metal particles 2, a target of single composition composed of elements forming the ferromagnetic metal particles 2, a combination of targets of single composition, and a combination of a target of single composition and an alloy target may be applied. A shutter 18 is placed above the target mount 15 (above the target 16). The operation of the shutter 18 is similar to the operation of the shutters 13, 14.

A substrate 19 and a heater 20 for heating the substrate 19 to a predetermined temperature are placed in the upper part of vacuum vessel 10. The undersurface of the substrate 19 in the figure is a deposition surface. Namely, monomers evaporated from the organics evaporating cells 11, 12 are deposited on the deposition surface of the substrate 19 while they are polymerized into a polymer, and metal atoms expelled from the target 16 are deposited on the deposition surface of the substrate 19. By carrying out sputtering and evaporation of monomers at the same time, a granular thin film comprising a polymer as the matrix 3 and fine ferromagnetic metal particles 2 dispersed in the matrix 3 can be formed.

For imparting a magnetic anisotropy to a granular thin film formed on the substrate 19, a pair of permanent magnets 21, 22 is placed around the substrate 19. Since a magnetic flux flows from the north pole of the permanent magnet 21 to the south pole of the permanent magnet 22, a magnetic anisotropy can be imparted to the granular thin film formed on the undersurface (deposition surface) of the substrate 19.

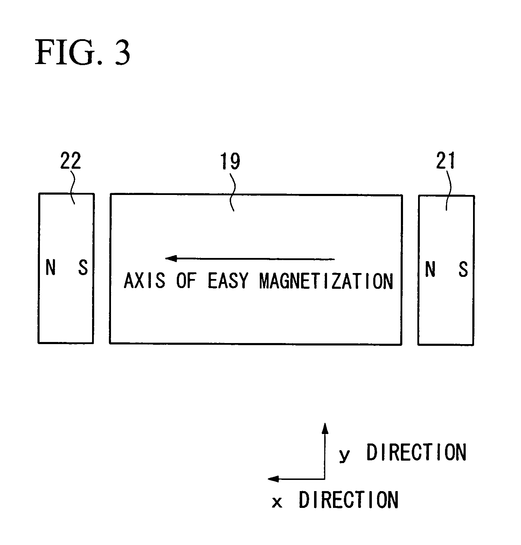

FIG. 3 is a plan view for explaining a magnetic anisotropy formed on a granular thin film. In FIG. 3, an axis of easy magnetization is formed along the x direction, and an axis of hard magnetization is formed along the y direction orthogonally crossing the x direction. The arrow shown in FIG. 2 indicates a direction along which the axis of easy magnetization is formed.

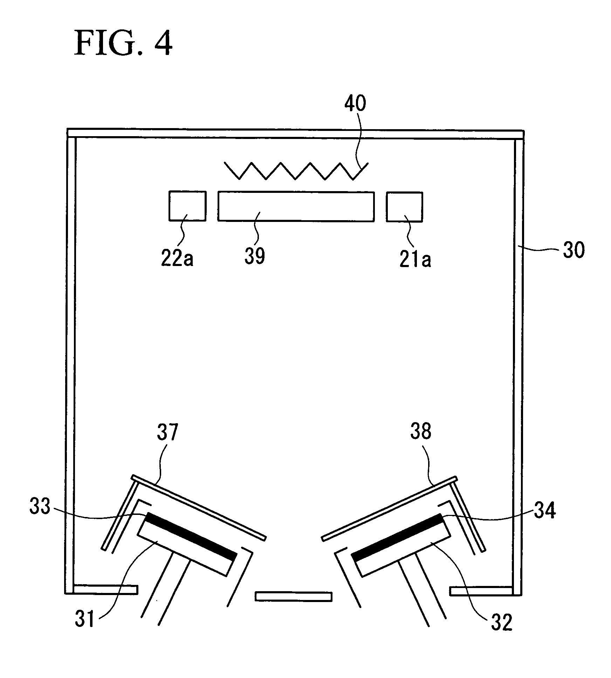

FIG. 4 shows an outlined configuration of a thin film forming apparatus capable of obtaining both the matrix 3 composed of a nonmagnetic insulating organic material and ferromagnetic metal particles 2 by sputtering.

The thin film forming apparatus of FIG. 4 has target mounts 31, 32 placed at a predetermined interval in the lower part in a vacuum vessel 30. Targets 33, 34 are mounted on the target mounts 31, 32, respectively. One of the two targets 33, 34 is intended for forming the matrix 3 composed of a nonmagnetic insulating organic material, and the other is intended for forming the ferromagnetic metal particles 2. A predetermined electric power is applied to the targets 33, 34 from a DC/RF power source (not shown), whereby ions are made to impinge on the targets 33, 34 at a high speed. Molecules or atoms of elements forming the targets 33, 34 are expelled from the surfaces of the targets 33, 34 on which ions have impinged at a high speed. Here, it is preferable that an RF power is supplied to the target for a nonmagnetic insulating organic material. The form of the target 33 (34) for formation of the matrix 3 is not specifically limited and, for example, a form of a polymer formed into a plate, a form of powdered polymer rolled out on a plate-like substrate, or the like may be employed. The target 33 (34) for formation of ferromagnetic metal particles 2 is same as described above. Shutters 37, 38 function as do the above shutters 13, 14. Permanent magnets 21a, 22a function for imparting a magnetic anisotropy to a granular thin film formed on the surface (deposition surface) of a substrate 39 as do the above permanent magnets 21, 22.

In the thin film forming apparatus of FIG. 4, a predetermined electric power is applied to the targets 33, 34 with the shutters 37, 38 opened, whereby a nonmagnetic insulating organic material forming the matrix 3 is sputtered and at the same time, a ferromagnetic metal forming the ferromagnetic metal particles 2 is sputtered. The sputtered nonmagnetic insulating organic material and ferromagnetic metal are deposited on the deposition surface of the substrate 39 heated to a predetermined temperature by a heater 40, whereby the granular substance 1 having the form of a thin film is formed.

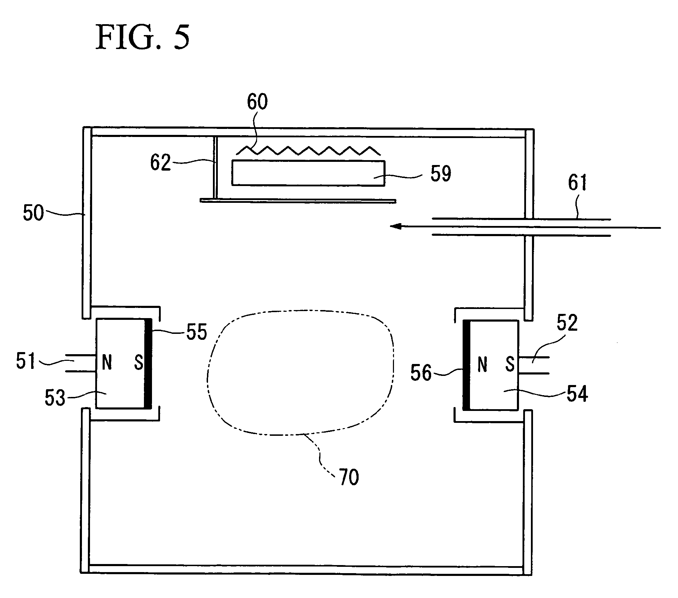

FIG. 5 shows an outlined configuration of a thin film forming apparatus capable of obtaining the matrix 3 composed of a nonmagnetic insulating organic material by a plasma polymerization method and obtaining the ferromagnetic metal particles 2 by sputtering.

The thin film forming apparatus of FIG. 5 has electrodes 51, 52 placed at a predetermined distance from each other in a face-to-face fashion in the side in a vacuum vessel 50. A permanent magnet 53 comprising a target 55 is mounted on the electrode 51, and a permanent magnet 54 comprising a target 56 is mounted on the electrode 52. Owing to existence of the permanent magnets 53, 54, a magnetic anisotropy is imparted to a granular thin film formed on a substrate 59. The targets 55, 56 are both intended for forming the ferromagnetic metal particles 2. A predetermined electric power is applied to the targets 55, 56 from a DC/RFpower source (not shown), whereby ions are made to impinge on the targets 55, 56 at a high speed. Molecules or atoms of elements forming the targets 55, 56 are expelled from the surfaces of the targets 55, 56 on which ions have impinged at a high speed. The forms and the like of the targets 55, 56 for formation of ferromagnetic metal particles 2 are same as described above.

The substrate 59, and a heater 60 heating the substrate 59 to a predetermined temperature are placed in the upper part of the vacuum vessel 50. The undersurface of the substrate 59 in the figure is a deposition surface.

In the thin film forming apparatus shown in FIG. 5, a fluorocarbon based gas is made to flow together with a sputtering gas, whereby a sputtering phenomenon and a plasma polymerization reaction of the target can be utilized at the same time. Namely, a sputtering gas such as Ar and a fluorocarbon based gas are introduced at the same time from a gas inlet 61, and metal particles expelled from the targets 55, 56 and a fluorocarbon based plasma polymerization product are made to coexist in a generated plasma 70, and are gathered on the deposition surface of the substrate 59. By carrying out sputtering while introducing the fluorocarbon based gas in this way, a granular thin film comprising a plasma polymer as the matrix 3 and fine ferromagnetic metal particles 2 dispersed in the matrix 3 can be formed. By controlling the partial pressure of the fluorocarbon gas, the amount of the matrix 3 produced in the granular thin film can be controlled.

For the fluorocarbon based gas, a single gas source selected from the group consisting of C₂F₄ and C₄F₈ can be used. Alternatively, a dual gas source including one type of fluorocarbon based gas having a high F/C ratio (e.g. C₂F₆, CF₄) and a gas causing a reduction in F/C ratio can be used. By introducing H₂, O₂ or N₂ into the plasma 70, desired mechanical and physical properties can be imparted to the granular thin film.

By the plasma polymerization reaction, the fluorocarbon based gas is formed into a fluorocarbon polymer. A typical fluorocarbon polymer is tetrafluoroethylene.

In the thin film forming apparatus of FIG. 5, a shutter 62 is placed below the substrate 59. The shutter 62 travels between a position for covering (for closing) the deposition surface of the substrate 59 and a position for uncovering (for opening) the deposition surface. FIG. 5 shows a state in which the shutter 62 is closed. At the time when molecules or atoms of elements forming the targets 55, 56 are expelled from the surfaces of the targets 55, 56, the shutter 62 is closed if it is not desired to deposit the molecules or atoms on the deposition surface of the substrate 59, and the shutter 62 is opened if it is desired to deposit the molecules or atoms on the deposition surface. By controlling the operation of the shutter 62, the thickness of the granular thin film can be controlled.

The thin film forming apparatus based on a faced-targets apparatus is shown in FIG. 5, but a sputtering apparatus of other type can be modified to obtain a granular thin film. For example, in the thin film forming apparatus shown in FIG. 2, the plasma polymerization method can be applied instead of the vapor deposition polymerization method. Namely, by making a monomer gas flow while carrying out sputtering at the same time in the thin film forming apparatus shown in FIG. 2, a granular thin film comprising a plasma polymer as the matrix 3 and fine ferromagnetic metal particles 2 dispersed in the matrix 3 can be formed.

The granular thin film of the present invention is a material most suitable for a high frequency integrated circuit fabricated by a semiconductor process, such as a monolithic microwave integrated circuit (MMIC). Thus, substrates on which the granular thin film of the present invention is formed may include, for example, semiconductor substrates of Si, Ga, As, InP, SiGe and the like. The granular thin film of the present invention can be formed on substrates of various ceramics materials and resins.

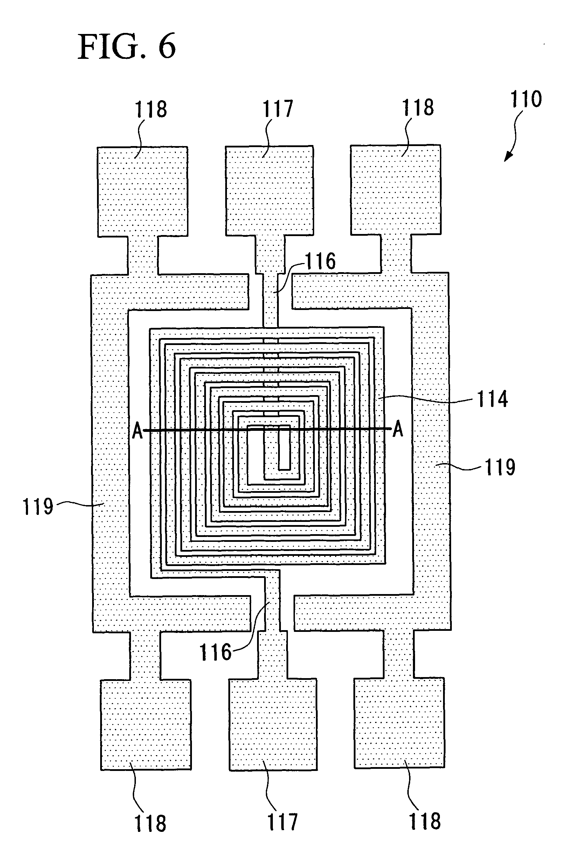

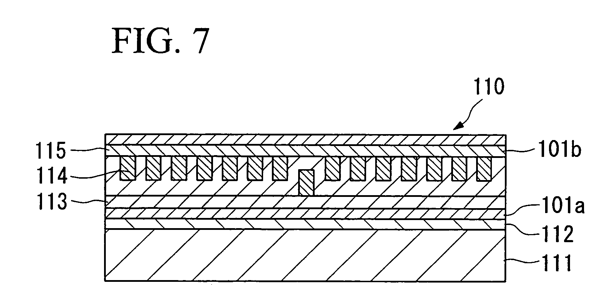

An example of application as an inductor used in MMIC is shown in FIGS. 6 and 7. FIG. 6 schematically shows a plan view excerpting a conductor layer portion of an inductor, and FIG. 7 is a view schematically showing a cross section taken along the A-A line of FIG. 6.

As shown in FIG. 7, an inductor 110 shown in these figures comprises a substrate 111, a oxidized insulating film 112 formed on the substrate 111 as required, a granular thin film 101a according to the present invention, formed on the oxidized insulating film 112, and an insulating film 113 formed on the granular thin film 101a, and further has a spiral coil 114 formed on the insulating film 113, an insulating film 115 formed in such a manner as to cover the spiral coil 114 and the insulating film 113, and a granular thin film 101b according to the present invention, formed on the insulating film 115.

The spiral coil 114 is connected to a pair of electrodes 117 via a wiring 116 as shown in FIG. 6. Ground patterns 119 provided such a manner as to surround the spiral coil 114 are each connected to a pair of ground electrodes 118, and have a shape such that frequency properties evaluated on a wafer by a ground-signal-ground (G-S-G) type probe.

In the inductor (inductor 110) used in MMIC according to this embodiment, a cored structure in which the spiral coil 114 is caught between the granular thin films 101a, 101b constituting a magnetic core, and therefore the inductance value is improved by about 50% compared with an inductor having a coreless structure in which the granular thin films 101a, 101b are not formed although the spiral coil 114 has the same shape. Thus, the area occupied by the spiral coil 114 required for obtaining the same inductance value may be low and as a result, a reduction in size of the spiral coil 114 is realized.

The material of the granular thin film applied to the inductor used in MMIC is required to have a high permeability in the high frequency of GHz region, and a high quality factor Q (low loss), and to be capable of integrated by a semiconductor production process.

For realizing a high permeability in the high frequency of GHz region, a material having a high resonance frequency and a high saturation magnetization is advantageous, and control of a uniaxial magnetic anisotropy is required. For obtaining a high quality factor Q, inhibition of an eddy current loss by an increase in resistance is required. Further, for application to an integration process, it is desirable that a film can be formed at room temperature, and the film can be used in an untreated state (state in which the film is not subjected to a treatment such as heat treatment) . The purpose is to prevent influences on the performance of other on-chip components that have been already set and on fabrication process.

### (Examples)

The present invention will now be described more in detail with specific examples.

### <First Example>

A granular thin film was formed using the thin film forming apparatus shown in FIG. 2.

For forming polyimide as a matrix composed of a nonmagnetic insulating organic material, dehydrated pyromellitic acid (hereinafter referred to as PMDA) and 4,4'-diaminodiphenylmethane (hereinafter referred to as ODA) were used as raw material monomers. PMDA was contained in the organics evaporating cell 11 and ODA was contained in the organics evaporating cell 12.

As a ferromagnetic metal, a Fe₆₉Co₃₁ (at%) alloy was employed. For this purpose, a Fe₆₉Co₃₁ (at%) alloy target was fabricated, and this target 16 was placed on the target mount 15.

For the substrate 19 on which the granular thin film was formed, a substrate 19 having SiO₂ deposited in a thickness of 500 nm on a Si (100) wafer was used. The surface on which a SiO₂ film is formed is a thin film deposition surface.

First, the vacuum vessel 10 was preliminarily evacuated to 8×10⁻⁵ Pa, and then an Ar gas was introduced so that the pressure in the vacuum vessel 10 was 0.2 Pa. With the shutter 18 closed, a DC power of 200 W was applied to the target 16 composed of a Fe₆₉CO₃₁ (at%) alloy via a DC electrode to carry out sputtering. Similarly with the shutters 13, 14 closed, the organics evaporating cell 11 containing PMDA was heated to 130°C, and the organics evaporating cell 12 containing ODA was heated to 120°C. A pair of permanent magnets 21, 22 was placed around the substrate 19, a magnetic field of 100 Oe or more was applied to the center of the substrate 19, and the temperature of the substrate 19 was kept at 150°C.

After elapse of predetermined time, the shutters 13, 14 and 18 are opened at the same time, whereby evaporated matters of PMDA and ODA and sputtered particles released from the target 16 travel toward the substrate 19. Fe₆₉Co₃₁ forming ferromagnetic metal particles were sputtered so that a film could be formed at a deposition rate of 1.2 nm (12 Å)/sec if a single layer film of Fe₆₉Co₃₁ was formed. For PMDA and ODA, the temperature in the organics evaporating cells 11, 12 were heated, and the like, were controlled so that a film could be formed at a deposition rate of 0.3 nm (3 Å) / sec if a single layer film of polyimide was formed. Under the conditions, a deposition was carried out for 5 minutes so that the granular thin film had a thickness of 450 nm.

For the obtained granular thin film, the volume ratio of the ferromagnetic metal particles is 80% and the volume ratio of the matrix is 20% based on calculation from the deposition rate. From X-ray diffraction patterns, it was recognized that fine ferromagnetic metal particles of bcc structure having a mean particle size of 7 nm were formed.

Magnetic properties were measured for the obtained granular thin film, and resultantly an in-plane uniaxial magnetic anisotropy was observed. The values of 13.3 kG (1.33 T) as a saturation magnetization, 3.5 Oe (278 A/m) as a coercive force and 750 Oe (5968 A/m) as an anisotropic magnetic field were obtained. The resonance frequency exceeded 2 GHz, i.e. a measurable limit, the real part of the permeability (µ') was 200 or more in the GHz region, and the quality factor Q (Q = µ'/µ") was 10 at 1 GHz. The resistivity was 260 µΩcm.

### <Second Example>

A granular thin film was obtained in the same manner as in the first example except that the ferromagnetic metal was changed to Fe. Magnetic properties were measured as in the first example, and resultantly the values of 12.1 kG (1.21 T) as a saturation magnetization, 4.0 Oe (318 A/m) as a coercive force and 70 Oe (55704 A/m) as an anisotropic magnetic field were obtained. The resonance frequency exceeded 2 GHz, i.e. a measurable limit, the real part of the permeability (µ') was 200 or more in the GHz region, and the quality factor Q (Q = µ'/µ") was 12 at 1 GHz. The resistivity was 250 µΩcm.

### <Third Example>

A granular thin film was fabricated in the same manner as in the first example except that 4,4'-diphenylmethane diisocyanate and benzenetetracarboxylic dianhydride were used as monomers, the organics evaporating cell 11 containing 4,4'-diphenylmethane diisocyanate was heated to 70°C, the organics evaporating cell 12 containing benzenetetracarboxylic dianhydride was heated to 140°C, and the substrate 19 was not heated. For 4,4'-diphenylmethane diisocyanate and benzenetetracarboxylic dianhydride, the temperature in the organics evaporating cells 11, 12, and the like, were controlled so that a film could be formed at a deposition rate of 0.125 nm/sec (1.25 Å/sec) if a single layer film of polyimide was formed.

The volume ratio of ferromagnetic metal particles in the obtained granular thin film was 90%, and the volume ratio of the matrix was 10%. From X-ray diffraction patterns, it was recognized that fine ferromagnetic metal particles of bcc structure having a mean particle size of 10 nm were formed. In the obtained granular thin film, an in-plane uniaxial magnetic anisotropy was observed, and the values of 17.5 kG (1.75 T) as a saturation magnetization, 2.5 Oe (198 A/m) as a coercive force and 70 Oe (55704 A/m) as an anisotropic magnetic field were obtained. The resonance frequency exceeded 2 GHz, i.e. a measurable limit, the real part of the permeability (µ') was 250 or more in the GHz region, and the quality factor Q (Q = µ'/µ") was 15 at 1 GHz. The resistivity was 110 µΩcm.

### <Fourth Example>

A granular thin filmwas formed using the thin film forming apparatus shown in FIG. 4.

Tetrafluoroethylene (trade name: Teflon (hereinafter referred to as PTFE)) was used as the matrix composed of a nonmagnetic insulating organic material. As a target for that purpose, a PTFE plate having a size of 100 mm and a thickness of 2 mm was prepared. A ferromagnetic metal was same as that of the first example, and a FeCo alloy target was prepared. The PTFE target and the Fe-Co alloy target were placed on the target mounts 31, 32. For the substrate 39, a substrate 39 having SiO₂ deposited in a thickness of 500 nm on a Si (100) wafer was used as in the first example.

The vacuum vessel 30 was preliminarily evacuated to 8×10⁻⁵ Pa, and then an Ar gas was introduced so that the pressure in the vacuum vessel 30 was 0.4 Pa. With the shutters 37, 38 closed, an RF power of 300 W was applied to the PTFE target and the Fe-Co alloy target via a DC/RF power source to carry out preliminary sputtering for 5 minutes. After completion of the preliminary sputtering, the shutters 37, 38 were opened at the same time, and PTFE and the FeCo alloy were gathered on the substrate 39 at the same time, whereby a thin film having a granular structure was formed. A film is formed at a deposition rate of 0.08 nm/sec (0.8 Å/sec) if a single layer film of the FeCo alloy is formed, and a film is formed at a deposition rate of 0.01 nm/sec (0.1 Å/sec) if a single layer film of PTFE is formed. Under the conditions, a deposition was carried out for 80 minutes so that the granular thin film had a thickness of 430 nm.

For the obtained granular thin film, the volume ratio of the ferromagnetic metal particles as calculated from the deposition rate is 88%, and the volume ratio of the matrix is 12%. From X-ray diffraction patterns, it was recognized that fine ferromagneticmetal particles of bcc structure having a mean particle size of 9 nm were formed.

Magnetic properties were measured for the obtained granular thin film, and resultantly an in-plane uniaxial magnetic anisotropy was observed. The values of 17.3 kG (1.73 T) as a saturation magnetization, 5.8 Oe (461 A/m) as a coercive force and 75 Oe (5968 A/m) as an anisotropic magnetic field were obtained. The resonance frequency exceeded 2 GHz, i.e. a measurable limit, the real part of the permeability (µ') was 200 or more in the GHz region, and the quality factor Q (Q = µ'/µ") was 15 at 1 GHz. The resistivity is 100 µΩcm.

### <Fifth Example>

A granular thin film was formed using the thin film forming apparatus shown in FIG. 5.

A C₄F₈ gas was used as a fluorocarbon based gas for forming the matrix composed of a nonmagnetic insulating organic material. An Ar gas was used as a carrier gas. A ferromagnetic metal was same as that of the first example, and a FeCo alloy target was prepared. The Fe-Co alloy target was placed on the target mounts 51, 52. For the substrate 59, a substrate 59 having SiO₂ deposited in a thickness of 500 nm on a Si (100) wafer was used as in the first example.

The vacuum vessel 50 was preliminarily evacuated to 8×10⁻⁵ Pa, the C₄F₈ gas and the carrier gas (Ar gas) were introduced from the gas inlet 61, and the overall gas pressure was adjusted to be 8 mTorr. At this time, the partial pressure of the C₄F₈ gas was varied within the range of 0 to 1.0 mTorr.

An RF power of 300 W was applied to the targets 53, 54 composed of the Fe-Co alloy via the electrodes 51, 52 to carry out preliminary sputtering for 5 minutes. The preliminary sputtering was carried out with the shutter 62 closed.

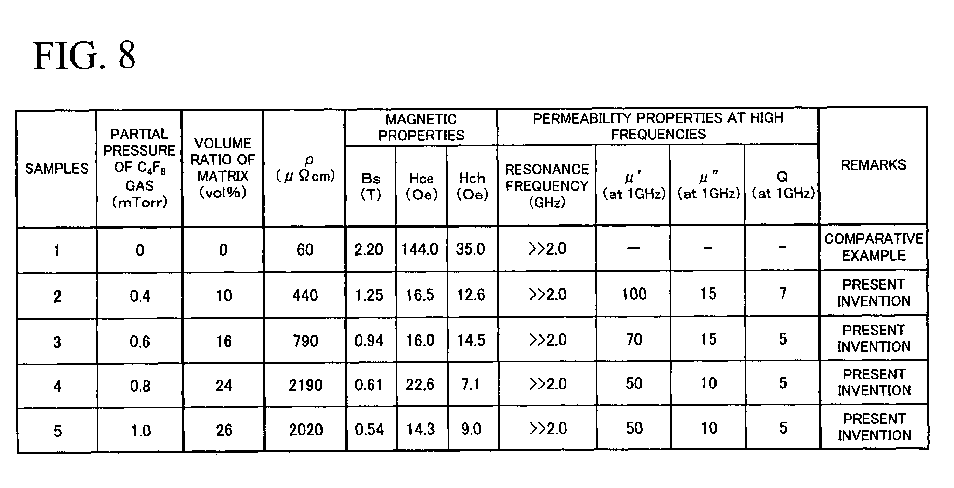

Then, the shutter 62 was opened, and a fluorocarbon polymer and the FeCo alloy were gathered on the substrate 59 at the same time, whereby a thin film having a granular structure was formed. A film is formed at a deposition rate of 0.15 nm/sec (1.5 Å/sec) if a single layer film of the FeCo alloy is formed, and a film is formed at a deposition rate of 0.25 nm/sec (2.5 Å/sec) if a granular thin film is formed of the FeCo alloy and the fluorocarbon polymer. Under the conditions, a deposition was carried out for 20 minutes so that the thickness of the granular thin film was 300 nm, and resultantly five kinds of thin films (samples No. 1 to 5) shown in FIG. 8 were obtained. For the obtained thin films, magnetic properties were measured. The results are shown in FIG. 8.

From FIG. 8, it can be understood that the saturation magnetization (Bs) and the resistivity (ρ) vary as the partial pressure of the C₄F₈ gas is changed. When the partial pressure of the C₄F₈ gas is 0 mTorr (sample No. 1), the saturation magnetization (Bs) is high, but a high resistivity (p) of 100 µΩcm or more cannot be obtained. For samples No. 2 to 5 of the present invention where the partial pressure of the C₄F₈ gas was in the range of 0.4 to 1.0 mTorr, a saturation magnetization (Bs) of 0.5 T (5.0 kG) or more and a resistivity (ρ) of 400 µΩm or more could be obtained. Samples No. 2 to 5 of the present invention exhibited satisfactory properties of 14.3 to 22. 6 Oe (1138 to 1800 A/m) as a coercive force (Hce: coercive force along the axis of easy magnetization) and 7.1 to 14.5 Oe (565 to 1154 A/m) as a coercive force (Hch: coercive force along the axis of hard magnetization). The resonance frequency exceeded 2 GHz, the real part of the permeability (µ') in the GHz region was 50 or more, and the quality factor Q (Q = µ' = µ") was 1 or more at 1 GHz. An in-plane uniaxial magnetic anisotropy was observed in the inventive samples No. 2 to 5.

The volume ratio of the matrix is shown in FIG. 8. The volume ratio of the matrix was determined by calculating the volume ratio (vol%) of an organic substance (fluorocarbon polymer) based on the value of the saturation magnetization (Bs).

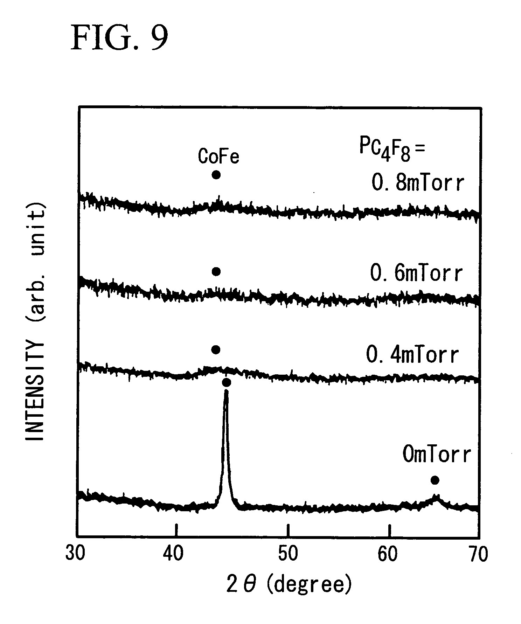

FIG. 9 shows X-ray diffraction patterns of samples No. 1 to 4. As shown in FIG. 9, a sharp peak of CoFe was observed when the partial pressure of the C₄F₈ gas (specified as P_{C4F8} in FIG. 9) was 0 mTorr (sample No. 1) . The sharp peak of CoFe disappears when the partial pressure of the C₄F₈ gas is 0.4 mTorr (sample No. 2) . When the partial pressure of the C₄F₈ gas was 0.6 mTorr (sample No. 3), and the partial pressure of the C₄F₈ gas was 0.8 mTorr (sample No. 4), the peak of CoFe was hardly observed.

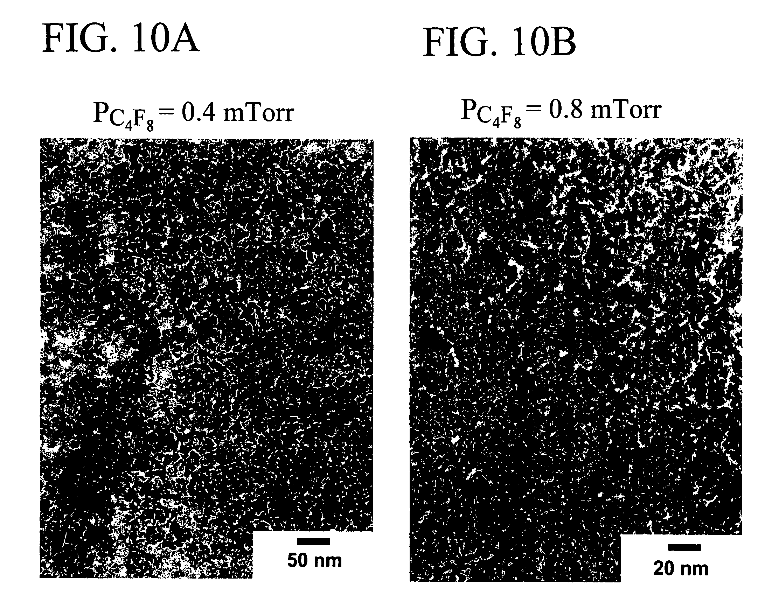

FIG. 10A is a TEM photograph of the sample No. 2 (partial pressure of the C₄F₈ gas: 0.4 mTorr), and FIG. 10B is a TEM photograph of the sample No. 4 (partial pressure of the C₄F₈ gas: 0.8 mTorr) . From comparison of FIG. 10A with FIG. 10B, it was recognized that the sample No. 4 where the partial pressure of the C₄F₈ gas was 0.8 mTorr was more advanced in nano-crystallization than the sample No. 2 (partial pressure of the C₄F₈ gas: 0.4 mTorr) . The mean grain size of the sample No. 2 was 19 nm, while the mean grain size of the sample No. 4 was 8 nm, and thus it was recognized from the measured values that the sample No. 4 was more advanced in nano-crystallization than the sample No. 2.

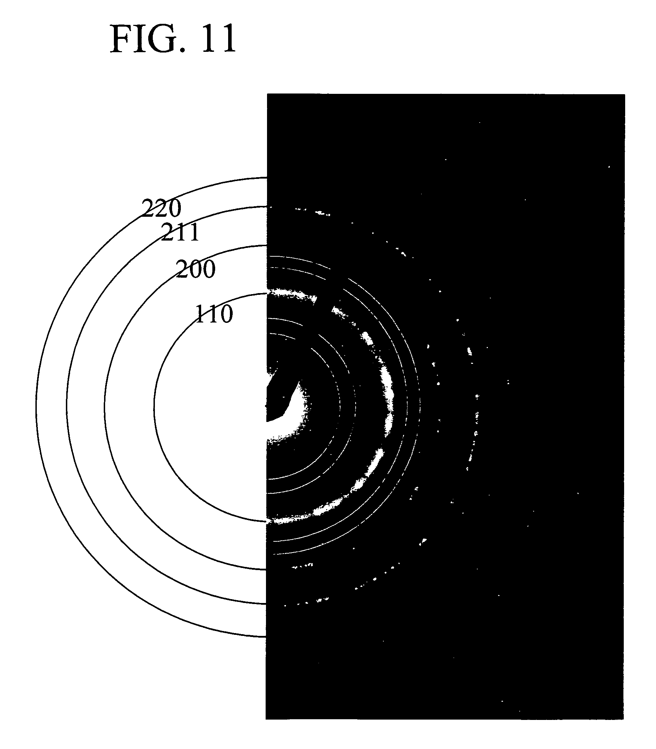

From an electron beam diffraction pattern (FIG. 11) described later, it was recognized that white parts between particles in FIGS. 10A and 10B showed the organic polymer forming the matrix, and other parts showed ferromagnetic metal particles. The width of the fluorocarbon polymer formed between particles is about 2 nm in the sample No. 2 and 2 to 5 nm in the sample No. 3.

The electron beam diffraction pattern of the sample No. 2 is shown in FIG. 11. As shown in FIG. 11, clear diffraction lines were observed at locations of (110), (200), (211) and (220). This shows diffraction from CoFe.

Diffraction lines were also observed from locations other than the locations of (110), (200), (211) and (220). As a result of evaluation using the X-ray diffraction card JCPDS (Joint Committee of Powder Diffraction Standard), it was found that the diffraction line coincided with the diffraction pattern of the X-ray diffraction card JCPDS 27-1837, and it was diffraction from the fluorocarbon polymer. Namely, from the fact that diffraction from FeCo and diffraction from the fluorocarbon polymer were observed at the same time, it was evident that a state of mixture of FeCo and the fluorocarbon polymer was created in the sample No. 2. As a result, it could be recognized that the structure shown in FIGS. 10A and 10B, i.e. a structure in which ferromagnetic metal particles are dispersed in an organic polymer is a granular structure.

### Industrial Applicability

According to the present invention is provided a granular substance and a granular thin film capable of being used as a magnetic thin film for high frequency having a high permeability in the high frequency of GHz region and having a high saturation magnetization.

## Claims

1. A granular substance **characterized by** comprising:
a matrix composed of a nonmagnetic insulating organic material; and
ferromagnetic metal particles dispersed in said matrix and having a mean particle size of 50 nm or less,
wherein the volume ratio of said matrix is in the range of 5 to 50%.

2. The granular substance according to claim 1,
**characterized in that** said ferromagnetic metal particles are formed of a metal mainly comprising at least one element selected from Fe, Co and Ni.

3. The granular substance according to claim 1,
**characterized in that** said ferromagnetic metal particles are formed of a metal mainly comprising Fe and Co.

4. The granular substance according to claim 3,
**characterized in that** the concentration of Co in said metal mainly comprising Fe and Co is in the range of 10 to 50 at %.

5. The granular substance according to claim 1,
**characterized in that** said ferromagnetic metal particles are spaced apart by a distance enabling exchange coupling therebetween.

6. The granular substance according to claim 1,
**characterized in that** said matrix is formed of an organic polymer.

7. The granular substance according to claim 1,
**characterized in that** the volume ratio of said matrix is in the range of 5 to 40%.

8. The granular substance according to claim 1,
**characterized in that** said granular substance is in the form of a film, and has a complex permeability the real part (µ') of which is 40 or more at 1 GHz, a quality factor Q (Q = µ'/µ" where µ" is the imaginary part of the complex permeability) of 1 or more, and a saturation magnetization of 5 kG or more.

9. The granular substance according to claim 8,
**characterized in that** the real part of the complex permeability (µ') is 50 or more at 1 GHz.

10. The granular substance according to claim 8 or 9,
**characterized in that** the quality factor Q (Q = µ'/µ" where µ' ' is the imaginary part of the complex permeability) is 5 or more.

11. The granular substance according to claim 8 or 9,
**characterized in that** the saturation magnetization is 6 kG or more.

12. The granular substance according to claim 1,
**characterized in that** the resistivity is 100 µΩcm or more.

13. A magnetic thin film having an in-plane magnetic anisotropy and having a thickness of 100 to 2000 nm,
**characterized in that**:
said magnetic thin film is a mixture of ferromagnetic metal particles mainly comprising at least one element selected from Fe, Co and Ni and having a mean particle size of 50 nm or less and an organic polymer; and
in said mixture, said ferromagnetic metal particles are spaced apart by a distance enabling exchange coupling therebetween.

14. The magnetic thin film according to claim 13,
**characterized in that** said ferromagnetic metal particles are formed of a metal mainly comprising Fe and Co.

15. The magnetic thin film according to claim 13,
**characterized in that** the mean particle size of said ferromagnetic metal particles is in the range of 5 to 15 nm.

16. The magnetic thin film according to claim 13,
**characterized in that** said organic polymer is a polyimide.

17. A magnetic device having a magnetic thin film for high frequency,
**characterized in that** said magnetic thin film for high frequency is formed of a granular substance comprising:
a matrix composed of a nonmagnetic insulating organic material; and
ferromagnetic metal particles dispersed in said matrix and having a mean particle size of 50 nm or less,
wherein the volume ratio of said matrix is in the range of 5 to 50%.

18. The magnetic device according to claim 17, **characterized in that** the mean particle size of said ferromagnetic metal particles is in the range of 5 to 30 nm.

19. The magnetic device according to claim 17, **characterized in that** said ferromagnetic metal particles are formed of a metal mainly comprising Fe and Co.

20. The magnetic device according to claim 17, **characterized in that** said matrix is formed of an organic polymer.

21. The magnetic device according to claim 20, **characterized in that**:
said organic polymer is a fluorocarbon polymer; and
the resistivity of said magnetic thin film for high frequency is 300 µΩcm or more.

22. The magnetic device according to claim 17, **characterized in that** said magnetic thin film for high frequency has a complex permeability the real part (µ') of which is 40 or more at 1 GHz, a quality factor Q (Q = µ'/µ" where µ" is the imaginary part of the complex permeability) of 1 or more, and a saturation magnetization of 5 kG or more.
